# EUROPEAN PATENT APPLICATION

(11) **EP 1 898 582 A1**
(43) Date of publication of application: **12.03.2008**
(21) Application number: 06018901.6
(22) Date of filing: 08.09.2006
(51) Int. Cl.: H04L 25/06, H03K 5/007

(54) **Method and apparatus for correcting duty cycle distortion**

(71) Applicant: Realtek Semiconductor Corp., Hsinchu 300 (TW)
(72) Inventor: Chou, Ger-Chih, San Jose, CA 95129 (US); Lin, Chia-Liang, Union City, CA 94587 (US)
(74) Representative: TER MEER - STEINMEISTER & PARTNER GbR

(57) **Abstract**

In one embodiment, DC offset is removed from an input signal to correct duty cycle distortion in a communications system receiver. The DC offset in the input signal may be determined by recovering clock and data signals from the logical signal, and then generating a correction voltage that may be applied to the input signal. A transition signal that represents a sampling of the logical signal at edges of the clock where symbol transitions occur may also be used in generating the correction voltage. The correction voltage may be indicative of the DC offset in the input signal and may be readily subtracted from the input signal.

## Description

### BACKGROUND OF THE INVENTION

### 1. Field of the Invention

The present invention relates generally to data communications, and more particularly but not exclusively to methods and apparatus for correcting duty cycle distortion.

### 2. Description of the Background Art

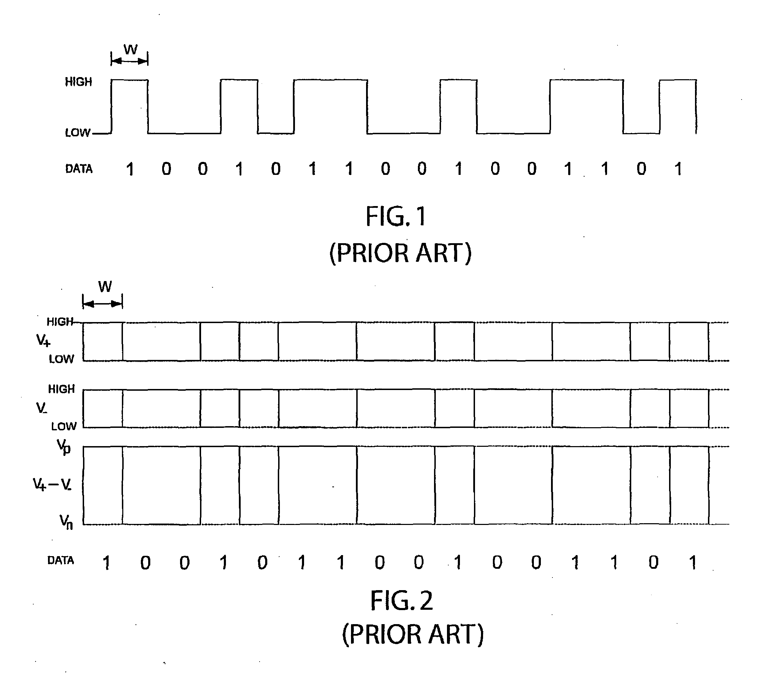

A typical data communications system comprises a transmitter, a communication media, and a receiver. Data may be modulated at the transmitter, transmitted over the communication media, and then demodulated at the receiver. Non-return to zero (NRZ) is an example modulation scheme used in digital data communications. In FIG. 1, an example waveform of an NRZ modulated signal is shown above its corresponding binary data representation. In an NRZ waveform, a logical "1" has a high voltage with a pulse width of "W", and a logical "0" has a low voltage also with a pulse width of "W." The pulse width "W" is the reciprocal of the data rate. An NRZ modulated signal has both clock and data information, and is thus not transmitted with a separate clock signal.

In practice, NRZ modulation is typically implemented in differential form. A differential voltage consists of a positive voltage V₊ and a negative voltage V₋. The V₋ voltage is subtracted from the V₊ voltage to obtain the differential voltage. That is, the differential voltage is equal to V₊- V₋. FIG. 2 shows, from top to bottom, waveforms for a voltage V₊, a voltage V₋, and resulting differential voltage (V₊- V₋). The binary data representation of the differential voltage waveform is shown on the bottom of FIG. 2. In the example of FIG. 2, a logical "1" is transmitted when V₊ is a high voltage pulse of width "W" and V₋ is a low voltage pulse of width "W." Similarly, a logical "0" is transmitted when V₊ is a low voltage pulse of width "W" and V₋ is a high voltage pulse of width "W." The differential voltage, V₊- V₋, equals a positive value Vₚ when a logical "1" is transmitted and equals a negative value Vₙ when a logical "0" is transmitted.

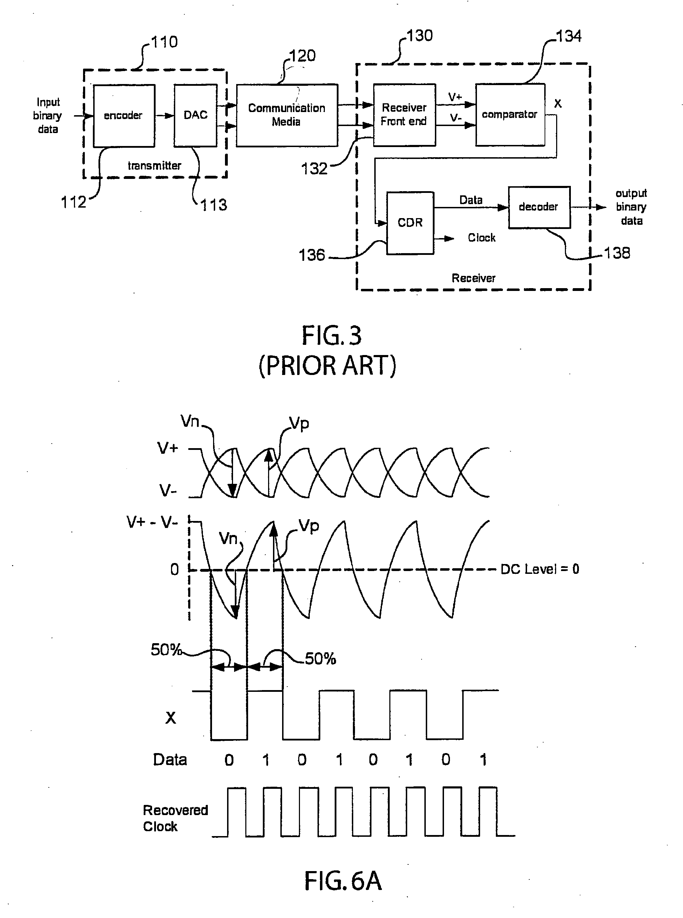

FIG. 3 schematically shows an example communications system employing NRZ modulation. The communications system of FIG. 3 includes a transmitter 110, a communication media 120, and a receiver 130. The transmitter 110 includes an encoder 112, such as an 8B10B encoder, for encoding input binary data to another binary data sequence. A digital to analog converter 113 in the transmitter 110 converts the logical (i.e., digital) output of the encoder 112 to analog form. In the example of FIG. 3, the digital to analog converter 113 outputs a differential voltage signal. The differential voltage signal is transmitted over the communication media 120 (e.g., transmission line) to the receiver 130. In the example of FIG. 3, the receiver 130 includes a receiver front-end 132, a comparator 134, a clock data recovery (CDR) circuit 136 and a decoder 138. The front-end unit 132 amplifies the differential voltage signal received over the communication media 120 (i.e., the input signal to the receiver 130), and generates output voltages V+ and V- in differential form. The comparator 134 compares the voltages V+ and V- to generate a logical signal "X," which is a representation of the differential voltage signal received over the communication media 120 in digital form. The logical signal "X" is input to the CDR circuit 136, which recovers the NRZ encoded data and the clock used by the transmitter 110 embedded in the NRZ waveform. The recovered encoded data is decoded by the decoder 138 to generate an output binary data sequence.

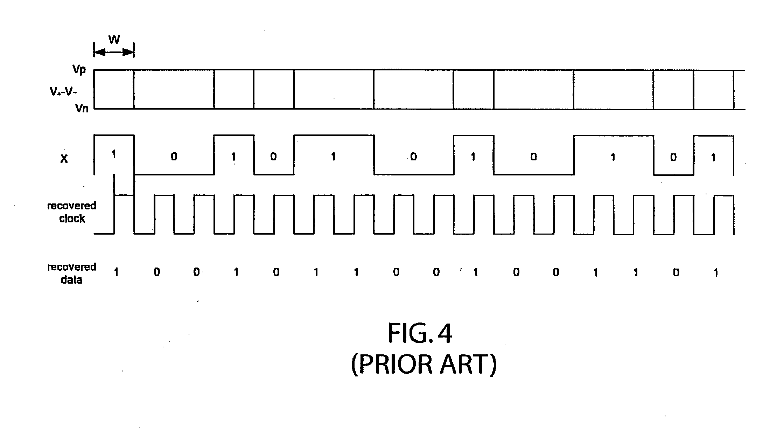

FIG. 4 shows example waveforms, from top to bottom, of a differential voltage signal (V+ - V-) input to the comparator 134, output of the comparator 134 (logical signal "X"), and recovered clock generated by the CDR circuit 136. The binary data representation of the data recovered by the CDR circuit 136 is shown on the bottom of F1G. 4. Note that the rising edge (also referred to as "leading edge") of the recovered clock should align with the middle of the NRZ pulse (logical signal "X" in this example), while the falling edge (also referred to as "trailing edge") of the recovered clock should align with the transition between NRZ pulses. In an ideal NRZ communications system, the spacing between transitions should always be a multiple of the pulse width "W."

In practice, an NRZ waveform will suffer from distortions brought about by the communication media or by circuitry in the transmitter or receiver. These distortions, if not addressed, may lead to irrecoverable errors that prevent the transmitted data from being properly read in the receiver.

### SUMMARY

In one embodiment, DC offset is removed from an input signal to correct duty cycle distortion in a communications system receiver. The DC offset in the input signal may be determined by recovering clock and data signals from a logical signal, and then generating a correction voltage that may be applied to the input signal. A transition signal that represents a sampling of the logical signal at edges of the clock where symbol transitions occur may also be used in generating the correction voltage. The correction voltage may be indicative of the DC offset in the input signal and may be readily subtracted from the input signal.

These and other features of the present invention will be readily apparent to persons of ordinary skill in the art upon reading the entirety of this disclosure, which includes the accompanying drawings and claims.

### DESCRIPTION OF THE DRAWINGS

FIG. 1 shows an example waveform of an example NRZ modulated signal.
FIG. 2 shows example waveforms of a differential voltage signal.
FIG. 3 schematically shows an example communications system employing NRZ modulation.
FIG. 4 shows example ideal waveforms in the communications system of FIG. 3.
FIGS. 5A and 5B show waveforms illustrating how jitter is affected by DC offset in a signal.
FIGS. 6A and 6B show waveforms illustrating how DC offset causes duty cycle distortion.
FIG. 7 schematically shows a clock data recovery (CDR) circuit that may be employed in embodiments of the present invention.
FIG. 8 shows example waveforms in the CDR circuit of FIG. 7.
FIG. 9 shows a duty cycle distortion (DCD) correction circuit in accordance with an embodiment of the present invention.
FIG. 10 shows example waveforms illustrating timing relationship between a logical input signal, a clock signal, a data signal, and a transition signal.
FIG. 11 shows example waveforms illustrating timing relationship between signals in a DCD correction algorithm in accordance with an embodiment of the present invention.
FIG. 12 schematically shows a differential DCD correction circuit in accordance with an embodiment of the present invention.
FIG. 13 schematically shows a single-ended DCD correction circuit in accordance with an embodiment of the present invention.
FIG. 14 schematically shows an optional equalizer used in conjunction with a DCD correction circuit in accordance with an embodiment of the present invention.
FIG. 15 schematically shows the DCD correction circuit of FIG. 9 being employed with an alternative CDR circuit in accordance with an embodiment of the present invention.
FIG. 16 schematically shows further details of the CDR circuit of FIG. 15 in accordance with an embodiment of the present invention.

The use of the same reference label in different drawings indicates the same or like components.

### DETAILED DESCRIPTION

In the present disclosure, numerous specific details are provided, such as examples of apparatus, circuits, components, and methods, to provide a thorough understanding of embodiments of the invention. Persons of ordinary skill in the art will recognize, however, that the invention can be practiced without one or more of the specific details. In other instances, well-known details are not shown or described to avoid obscuring aspects of the invention.

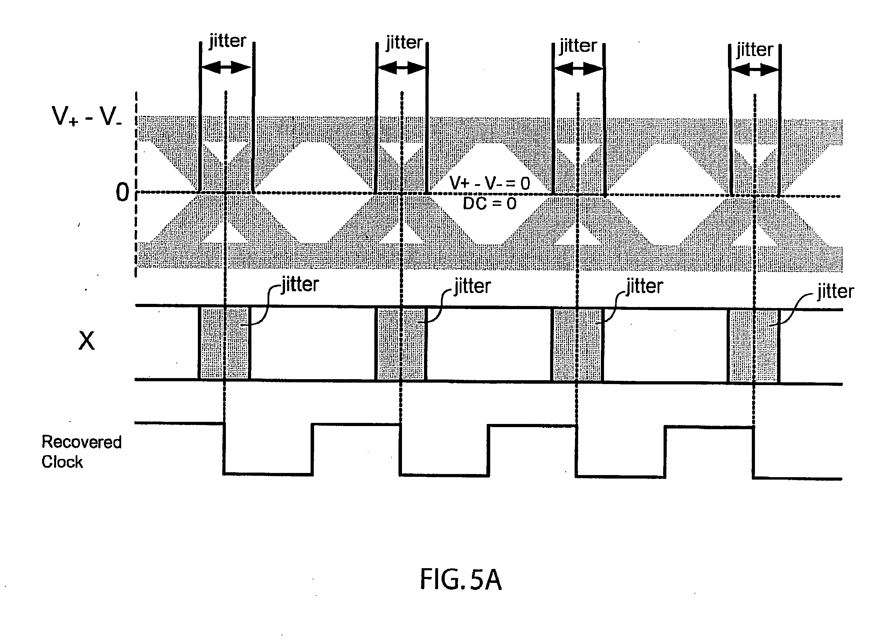

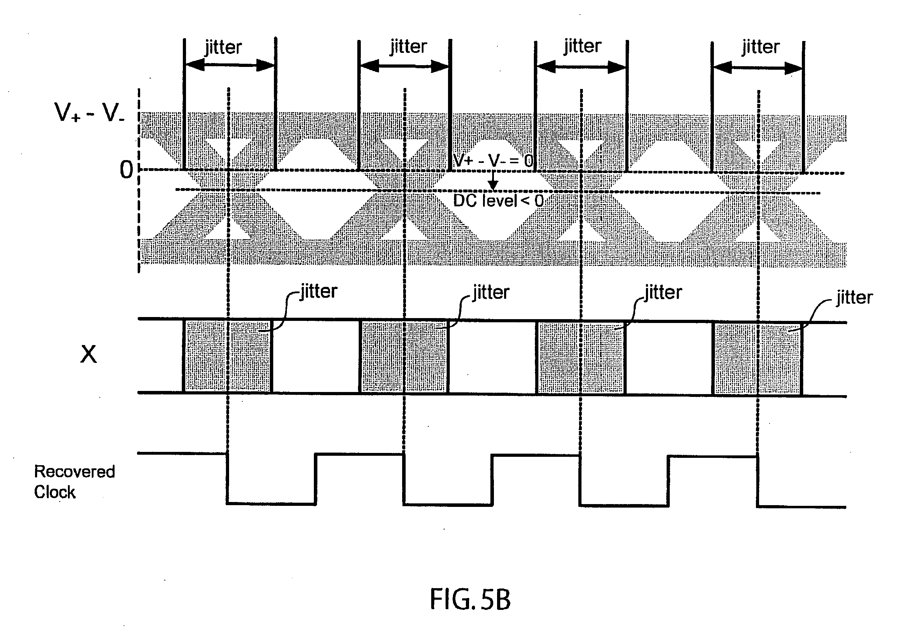

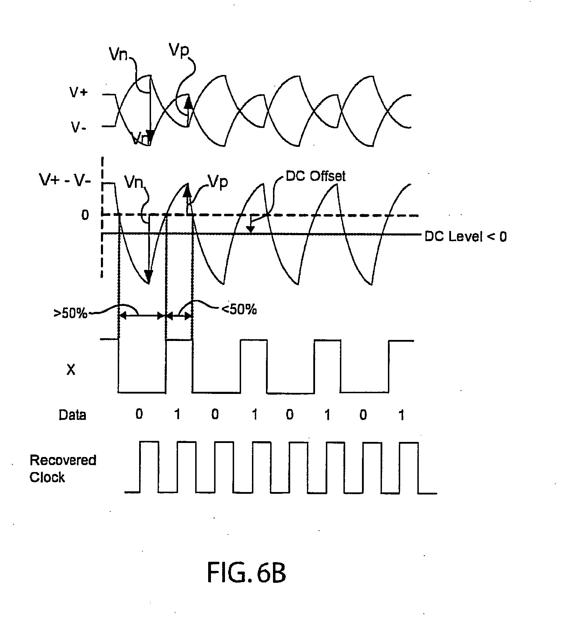

Without being limited by theory, the mechanisms the inventors believe lead to duty cycle distortion in NRZ modulated signals are now discussed with reference to FIGS. 5 and 6.

If a differential NRZ modulated signal is encoded with a DC balanced code (e.g., the 8B10B code) and the rise and fall transition times of the NRZ modulated signal are symmetrical, the long term average voltage (i.e., DC level) of the NRZ modulated signal will be zero. However, due to distortions in a communications system, the waveform of a differential voltage signal may deviate significantly from ideal waveforms (e.g. those shown in FIGS. 2 and 4). These distortions may prevent the differential voltage signal from swinging between Vp and Vn, and may also prevent the spacing between transitions from being a multiple of pulse width "W." That is, the falling edges of the recovered clock will not always align with symbol (i.e., data bit) transitions.

A DC offset may also be introduced by receiver circuitry such that the long term average of the differential voltage signal will deviate from zero even if the remote transmitter is sending a DC balanced data sequence. ln the absence of a DC offset, the waveform of the differential voltage signal will resemble a so-called "eye diagram" when viewed using an oscilloscope. FIG. 5A shows, from top to bottom, waveforms of a differential voltage signal (V₊- V₋) without DC offset, logical signal "X" output of a comparator (e.g., the comparator 134 shown in FIG. 3) receiving the differential voltage signal, and recovered clock (e.g., output of the CDR circuit 136). As shown in FIG. 5A, the high-to-low and low-to-high transitions of the logical signal "X" may not align with the falling edges of the recovered clock, and instead be spread out around the falling edges of the recovered clock. The extent of the spreading out of the data transitions is also referred to as "jitter." Excessive jitter may result in communication errors, and is thus advantageously minimized.

Referring to the differential voltage signal (V₊-V₋) of FIG. 5A, note that the maximum horizontal "eye opening" occurs at V₊-V₋=0. That is, for a differential voltage signal with zero DC offset, the maximum eye opening occurs when the differential voltage signal is at zero volts. ln the presence of DC offset, the maximum eye opening will no longer occur when the differential voltage signal is at zero volts. FIG. 5B shows how the logical signal "X" is affected by a negative DC offset in the differential voltage signal (V₊-V₋). Because data transitions are detected whenever zero crossings of V₊-V₋ occurs, the transitions are now further spread out. That is, the presence of the DC offset increased the jitter.

The above-described DC offset problem may lead to duty cycle distortion (DCD). FIG. 6A shows, from top to bottom, waveforms of V₊ and V₋ voltages, a differential voltage signal (V₊-V₋) with zero DC offset, logical signal "X" output of a comparator receiving the differential voltage signal, binary representation (labeled as "data") of the logical signal "X," and recovered clock. In the example of FIG. 6A, the differential voltage signal is for a data sequence of alternating 1's and 0's. In the absence of DC offset, the alternating 1's and 0's data pattern leads to a periodic differential voltage signal waveform centered at zero volts. This causes the logical signal "X" output to alternate between high (logical "1") and low (logical "0"), with the duration of the high being the same as the duration of the low. The waveform of the logical signal "X" output is thus a square wave with 50% duty cycle.

FIG. 6B shows how the waveforms of FIG. 6A are affected by a negative DC offset in the differential voltage signal. The negative DC offset in the differential voltage signal may be due to the shifting of the V₊ voltage and/or V₋ voltage as shown in FIG. 6B. With the DC offset, the alternating 1's and 0's data pattern results in a differential voltage signal waveform centered away from zero volts. In this case, the logical signal "X" output of the comparator still periodically alternates between high and low, but the duration of the lows is now longer than the duration of the highs. The waveform of the logical signal "X" output now has a square wave with a duty cycle less than 50%. Duty cycle distortion is considered to be present whenever the duty cycle deviates from the ideal value of 50%. In embodiments of the present invention, duty cycle distortion may be corrected or minimized by addressing the DC offset.

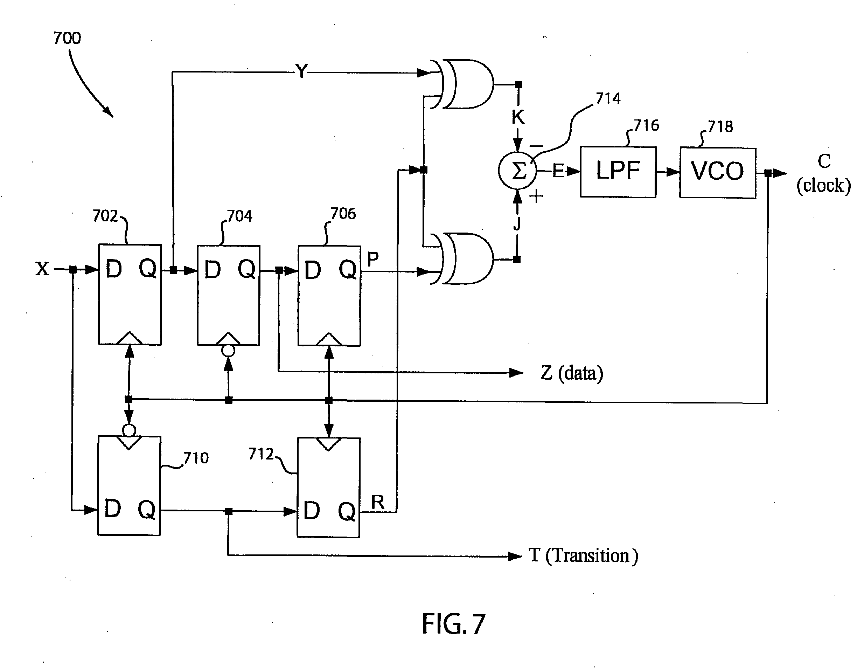

FIG. 7 schematically shows a clock data recovery (CDR) circuit 700 that may be employed in embodiments of the present invention. ln the example of FIG. 7, the CDR circuit 700 generates recovered clock and re-timed data from NRZ modulated data. The CDR circuit 700 receives a logical signal "X" from a comparator (e.g., comparator 134 shown in FIG. 3) and outputs a clock signal "C", transition signal "T", and data signal "Z". The logical signal "X" is in NRZ modulated form. The clock signal "C" and the data signal "Z" are the recovered clock and re-timed data, respectively, from the logical signal "X." ln the example of FIG. 7, the transition signal "T" is a sample of the logical signal "X" at the falling edges of the clock signal "C." That is, the transition signal "T" is a sample of the logical signal "X" at edges of the clock signal "C" where symbol (i.e., data bit) transitions occur. Still referring to FIG. 7, the logical signal "X" is sampled by the flip-flop 702 at the rising edge of the clock "C", resulting in the signal "Y." The signal "Y" is sampled by the flip-flop 704 at the falling edge of the clock "C," resulting in the data signal "Z." The data signal "Z" is sampled by the flip-flop 706 to generate the signal "P."

The logical signal "X" is also sampled by the flip-flop 710 at the falling edge of the clock "C" to produce the transition signal "T." The transition signal "T," in turn, is sampled by the flip-flop 712 at the rising edge of the clock signal "C" to generate the signal "R." Signals "J" and "K" are generated from the signals "R," "Y," and "P." Signal "J" is the exclusive OR" (i.e., EXOR) of signals "R" and "P," while the signal "K" is the "exclusive OR" of the signals "R" and "Y." A summer 714 receives signals "K" and "J" and outputs a phase difference signal pulse "E." The polarity of the phase difference signal pulse "E" reflects the phase relationship of the clock signal "C" relative to the logical signal "X". The phase difference signal pulse "E" is filtered by a low pass filter 716 and then used to control a voltage controlled oscillator (VCO) 718, which generates the clock signal "C." The clock signal "C" is used to sample the logical signal "X," thereby forming a phase locked loop that adjusts the phase of the clock signal "C" until its falling edges track the transitions of the logical signal "X" and its rising edges are aligned with the middle of each data symbol (i.e., data bit) of the logical signal "X."

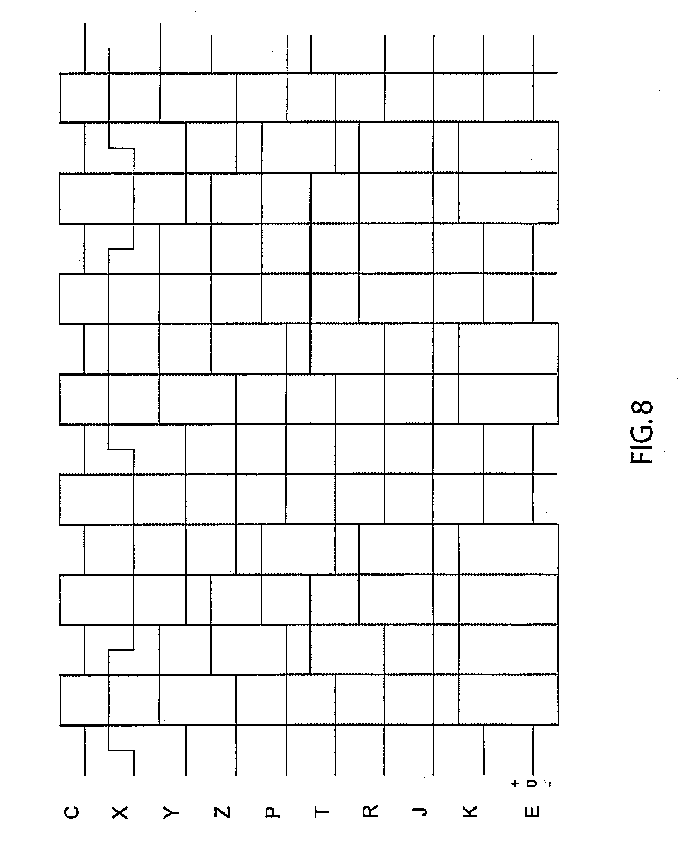

The operation of the phase difference signal pulse "E" is now further described with reference to FIG. 8, which shows example waveforms in the CDR circuit 700. FIG. 8 shows, from top to bottom, example clock signal "C", logical signal "X", signal "Y", data signal "Z", signal "P", transition signal "T", signal "R", signal "J", signal "K", and phase difference signal pulse "E". The waveforms of FIG. 8 are for the example where the phase of the clock signal "C" is initially too early compared to the ideal sampling phase (i.e. rising edge in the middle of the symbol). Assume for now that the input logical signal "X" to the CDR circuit 700 comprises an ideal NRZ data stream. In the case where the phase of the clock signal "C" is too early compared to the ideal sampling phase, the falling edge of the clock signal "C" will be ahead of the transition of the symbols represented by the logical signal "X." Then, whenever there is a data transition, there will be a pulse in signal "K," whose width is always equal to one clock cycle and independent of the actual phase difference between the logical signal "X" and the clock signal "C." (This is a reason why this type of phase detector is also referred to as a "Binary Phase Detector.") At the same time, there will be no pulse in the signal "J." The time-average of the phase difference signal pulse "E" (phase of signal "J" minus the phase of the signal "K") will then be negative. This negative value of the phase difference signal pulse "E" will eventually drag down the frequency (and phase) of the clock signal "C" output of the VCO 718 to narrow the phase difference between the falling edge of the clock signal "C" and the symbol transition of the logical signal "X."

Similarly, when the phase of the clock signal "C" is too late compared to the ideal sampling phase, there will be a pulse in the signal "J" upon data transition but no pulse in the signal "K." The time average of the phase difference signal pulse "E" will then be positive. This positive value of the phase difference signal pulse "E" will eventually pull up the frequency (and phase) of the clock signal "C" of the output of the VCO 718 to narrow the phase difference between the falling edge of the clock signal "C" and the symbol transition of the logical signal "X."

The phase-locked loop (PLL) functionality of the CDR circuit 700 thus allows for the alignment of the falling edge of the clock signal "C" with data transition. When a lock has been achieved, the phase difference signal pulse "E" will have a time-average value of zero. At that time, there will be equal number of signal "J" pulses and signal "K" pulses. In other words, the falling edge of the clock signal "C" will fall into the center of the accumulation of transitions of the input logical signal "X" so that the number of transition edges ahead is equal to the number of transition edges behind. This allows the rising edge of the clock signal "C" to align to the middle of the opening of the "eye diagram."

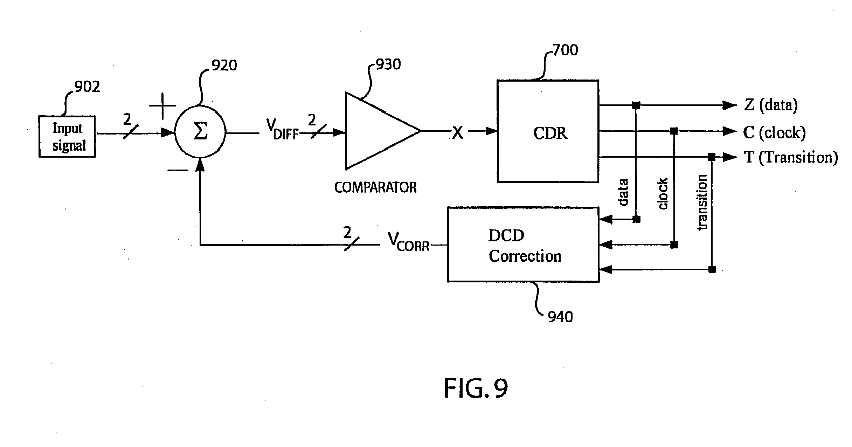

Turning now to FIG. 9, there is shown a duty cycle distortion (DCD) correction circuit 940 in accordance with an embodiment of the present invention. In the example of FIG. 9, the DCD correction circuit 940 works in conjunction with a summer circuit 920, a differential comparator 930, and a CDR circuit 700 such as that shown in FIG. 7. Other CDR circuits may also be adapted to work with the DCD correction circuit 940 without detracting from the merits of the present invention. Generally speaking, the DCD correction circuit 940 determines the amount of DC offset that may be present in an input signal based on the data, clock, and transition signal outputs of the CDR circuit 700. The DCD correction circuit 940 then generates a corresponding correction voltage, which is applied (by subtraction in this example) to the input signal using the summer circuit 920. The correction voltage may be indicative of the DC offset present in the input signal 902. In one embodiment, the correction voltage is an analog DC voltage having a magnitude that approximates the amount of DC offset in the input signal 902. The correction voltage may thus be subtracted from the input signal to remove DC offset therefrom, thereby minimizing or eliminating duty cycle distortion after one or more correction cycles.

In the example of FIG. 9, the DCD correction circuit 940, the summing circuit 920, and the comparator 930 work in differential mode. Accordingly, the correction voltage output, V_{CORR}, of the DCD correction circuit 940 consists of two analog voltages, namely a V_{CORR+} voltage (positive correction voltage) and a V_{CORR-} voltage (negative correction voltage). Similarly the input signal 902 to the summer circuit 920 is a differential voltage output of a receiver front end (e.g., receiver front end 132 shown in FIG. 3), and consists of an input V₊ voltage and an input V₋ voltage. In one embodiment, the differential summer circuit 920 subtracts the differential V_{CORR} voltage from the differential input signal 902. That is, the differential summer circuit 920 subtracts the V_{CORR+} - V_{CORR-} voltage signal from the input V₊ - V₋voltage signal and results in another differential voltage V_{DIFF} such that V_{DIFF}=V_{DIFF+}-V_{DIFF-}=(V₊ - V₋)-(V_{CORR+} - V_{CORR-}). This advantageously allows for removal of DC offset from the differential input signal 902. The output of the summer circuit 920 is thus a differential voltage V_{DIFF} consisting of V_{DIFF+} voltage and V_{DIFF-} voltage that have reduced (or free of) DC offset, thereby minimizing duty cycle distortion in the logical signal "X" output of the comparator 930. The CDR circuit 700 receives the logical signal "X" from the comparator 930 and uses the logical signal "X" to output retimed data ("Z"), recovered clock ("C"), and transition ("T") signals. The retimed data signal "Z" may be provided to another circuit, such as a decoder (e.g., see the decoder 138 shown in FIG. 3), for further processing.

The DCD correction circuit 940 may comprise analog circuitry, digital circuitry, or both. In one embodiment, the DCD correction circuit 940 functions in accordance with the algorithm shown in Table 1, also referred to as the "first algorithm."

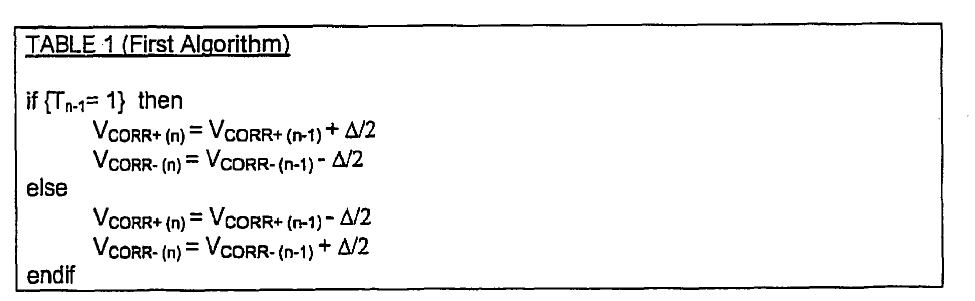

In the algorithm of Table 1, V_{CORR+(n)} and V_{CORR-(n)} are correction voltages generated by the DCD correction circuit 940 at time index "n," "Tₙ" is the value of the transition signal "T" at time index "n," and "Δ" is the adaptation step size. The adaptation step size Δ may be a predetermined value that is preferably small enough to take into account low noise that may affect the input signal. The adaptation step size Δ may be in the range of tenths of millivolts, for example. The first algorithm of Table 1 is based on the principle that upon DC balance, the transition samples (i.e., values of transition signal "T") should be equally likely distributed between 1's and 0's. That is, a DC balanced signal should have as much 1's as 0's, and any bias for one versus the other is indicative of a DC offset in the signal. When the transition signal "T" is biased towards a logical "1," the input signal is likely to have a positive DC offset, thus requiring subtraction of a positive correction voltage from the input signal. Conversely, when the transition signal 'T' is biased towards a logical "0," the input signal is likely to have a negative DC offset, thus requiring subtraction of a negative correction voltage from (which is mathematically equivalent to adding a DC offset to) the input signal. When there is equal distribution of 1's and 0's in the transition signal "T," it is likely that the input signal is DC balanced.

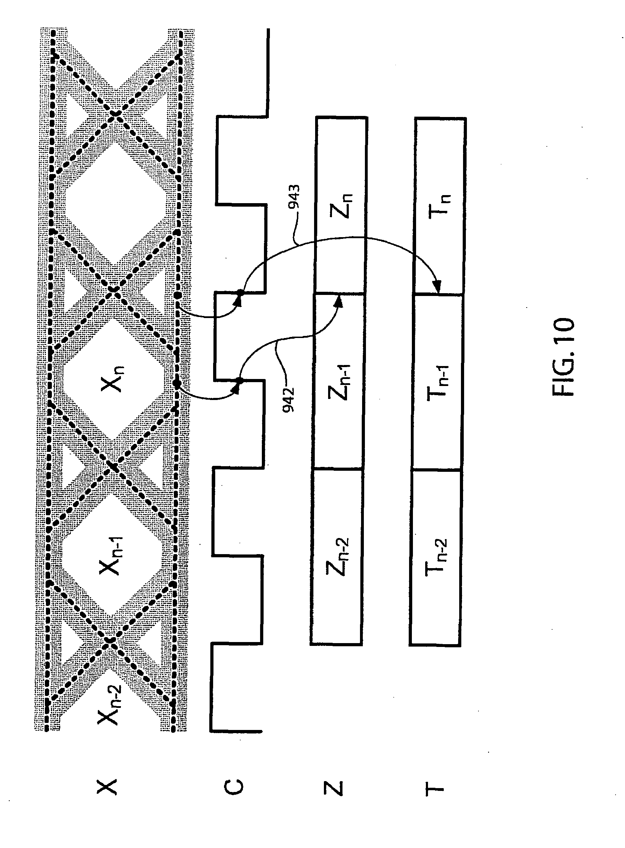

FIG. 10 shows, from top to bottom, example waveforms of the logical signal "X" values of the associated analog input signal "V_{DIFF+}-V_{DIFF-}", the clock signal "C," the data signal "Z," and the transition signal "T" as employed in the algorithms disclosed herein. The waveforms of FIG. 10 illustrate the relationship between the aforementioned signals at time indexes "n" (current), "n-1" (previous), and so on. Ideally, the rising edge of the clock signal "C" should line up in the middle of the symbol (i.e., data bit) of the logical signal "X" at time index "n," triggering the transition of the data signal "Z" to the new value Zₙ (see arrows 942). Also, the falling edge of the clock signal "C" should ideally line up with the transition of the symbol of the logical signal "X," triggering the new transition signal value Tₙ (see arrows 943).

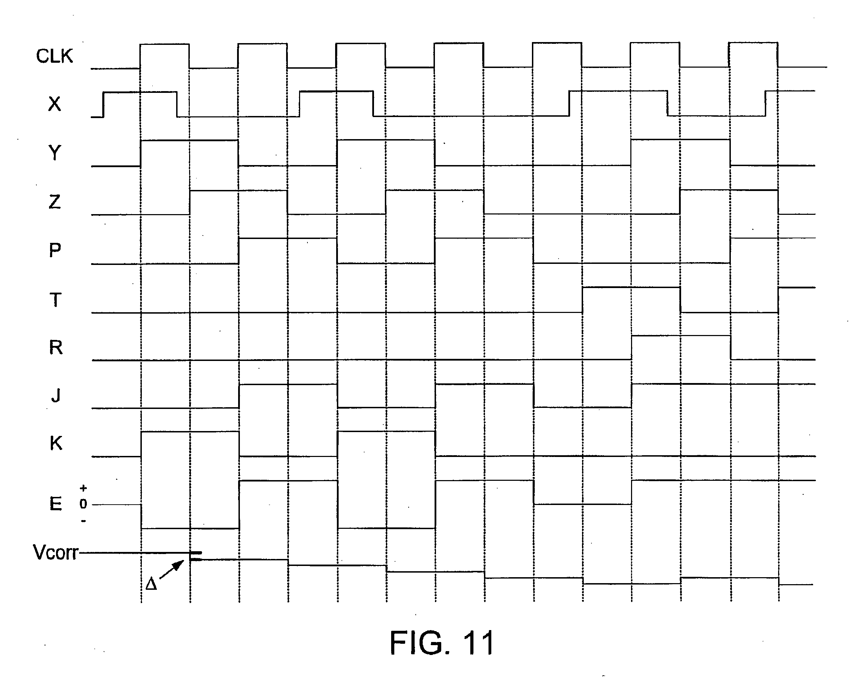

In the first algorithm of Table 1, the differential correction voltage V_{CORR} (i.e., V_{CDRR+} - V_{CORR-}) is derived from the extraction of the DC offset from the analog differential signal "V_{DIFF}" input to the comparator 930. This advantageously allows correction of duty cycle distortion to be readily performed by simply subtracting the correction voltage from the input signal 902. FIG. 11 shows example timing relationships between, from top to bottom, the clock signal ("C"), the logical signal "X," the signal "Y," the data signal "Z," the signal "P," the transition signal "T," the signal "R," the signal "J," the signal "K," phase difference signal "E," and the differential correction voltage V_{CORR} (i.e., V_{CORR+}- V_{CORR-}). Nodes where the aforementioned signals appear are shown in FIGS. 7 and 9. The adaptation step size Δ is also shown in FIG. 11 in conjunction with the correction voltage V_{CORR}. In the example of FIG. 11, the initial DC offset is negative, resulting in the positive pulses of the logical signal "X" being narrower than the negative pulses. This results in a negative amount of DC voltage developing on the correction voltage V_{CORR}. The negative correction voltage V_{CORR} is then subtracted from the differential signal input to the comparator to remove the DC offset from the input signal. After one or more correction cycles, this leads to a balanced ratio of positive pulses and negative pulses in the logical signal "X" output of the comparator.

Note that the phase difference signal pulse "E" maintains an average zero level when the input signal has duty cycle distortion. This means that duty cycle distortion will affect the jitter of the input signal but not the frequency or phase of the recovered clock. Therefore, the mechanism behind the first algorithm of Table 1 is based upon the lock of the CDR circuit 700. Once the CDR circuit 700 gets a lock, it will improve the jitter and hence the bit error rate.

As is apparent from the example of FIG. 11, the correction voltage V_{CORR} will continue to accumulate if the data signal "Z" stays on a fixed value for a while. In that case, the transition signal "T" will be identical to the data signal "Z" even though there is no transition on the data bits boundary. A second algorithm that removes the extra accumulation of correction voltage is shown in Table 2.

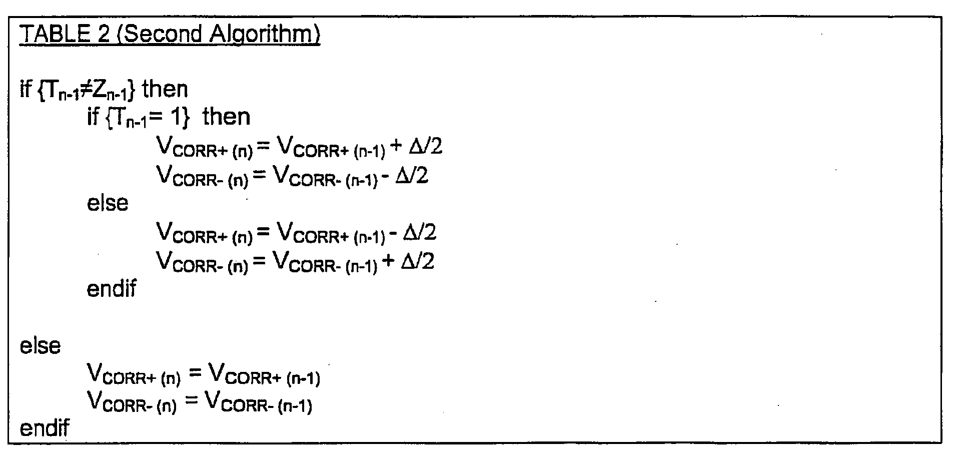

The parameters of the second algorithm of Table 2 are the same as those of the first algorithm of Table 1 with the addition of "Zₙ", which is the value of the data signal "Z" at time index "n." In the second algorithm of Table 2, the differential correction voltage V_{CORR} is adjusted only when the transition signal "T" and the data signal "Z" are not the same. Otherwise, the value of the correction voltage V_{CORR} is not changed. This advantageously prevents extraneous accumulation of the correction voltage.

Since the transition signal "T" is meaningful only when a transition in the input logical signal "X" to the CDR circuit 700 occurs, the correction signal can be precisely tailored to reduce the unwanted over-accumulation. A third algorithm that may be employed by the DCD correction circuit 940 is shown in Table 3.

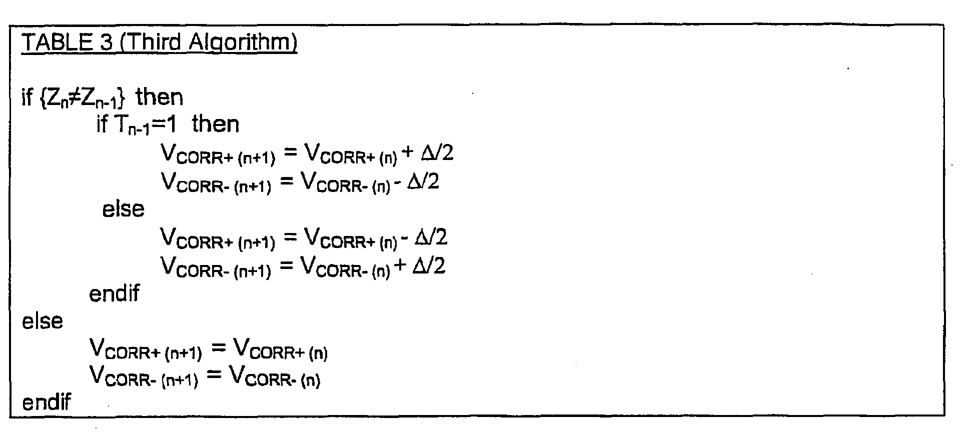

The parameters of the third algorithm of Table 3 are the same as those of the second algorithm of Table 2. In the third algorithm of Table 3, the differential correction voltage V_{CORR} is adjusted only when two consecutive data bits of the data signal "Z" change (i.e., when there is a symbol transition). Otherwise, the value of the correction voltage V_{CORR} is not changed in the next time index (i.e., n+1). This advantageously avoids over correction that may be due to accumulation of excess amounts of correction voltages when there are consecutive 1's and 0's. It can be observed that the correction voltage V_{CORR} may be calculated with an extra cycle delay to allow the observation of a transition by comparing the data signal "Z" at time indexes "n" and "n-1" (i.e., "Zₙ" and "Zₙ₋₁").

It is to be noted that although the above algorithms have been discussed in the context of differential voltage signals, they are not so limited and may also be implemented in single-ended communications systems.

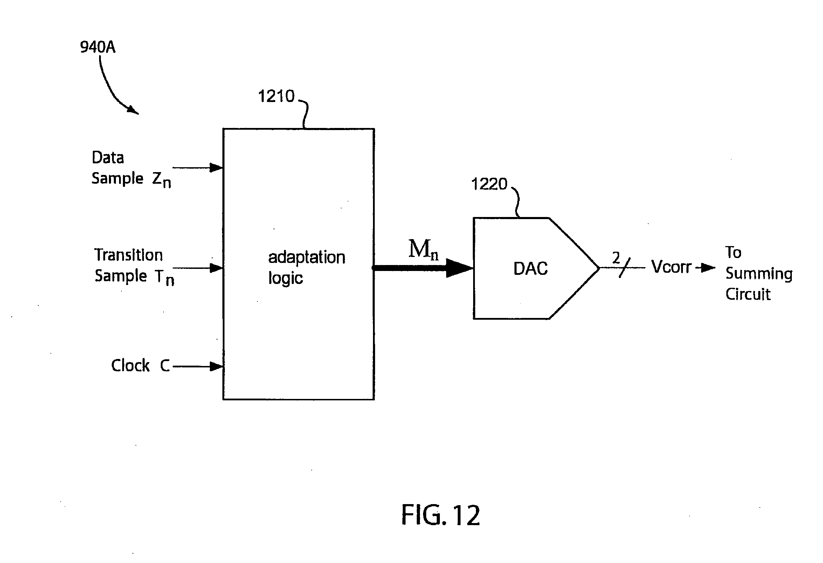

FIG. 12 schematically shows a DCD correction circuit 940A in accordance with an embodiment of the present invention. The DCD correction circuit 940A is a specific embodiment of the DCD correction circuit 940 shown in FIG. 9. In the example of FIG. 12, the DCD correction circuit 940A includes an adaptation logic 1210 and a digital to analog converter (DAC) 1220. The adaptation logic 1210 may comprise individual gates, programmable logic device, or other logic circuitry configured to perform any of the three previously described DCD correction algorithms. ln one embodiment, a digital counter with multi-bit output Mₙ is implemented in the adaptation logic 1210 to accumulate a correction voltage in digital form. The multi-bit output Mₙ is applied to the DAC 1220 to generate a correction voltage. In the example of FIG. 12, the DAC 1220 is configured to generate a differential correction voltage V_{CORR} consisting of a V_{CORR+} voltage and a V_{CORR-} voltage on two separate lines going to a summer circuit (e.g., see summer circuit 920 shown in FIG. 9). For example, the DAC 1220 may have an output circuit that converts a single-ended output voltage to a pair of voltages in differential form. The algorithms of Tables 1, 2, and 3 may be adjusted to produce the multi-bit output Mₙ as shown in Tables 1A, 2A, and 3A, respectively. The algorithms of Tables 1A, 2A, and 3A operate on essentially the same principles as those of Tables 1, 2, and 3, respectively.

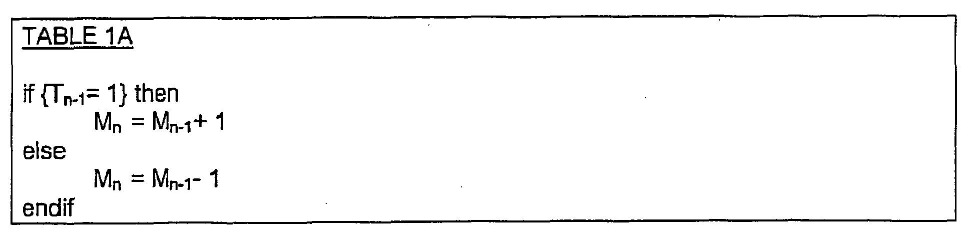

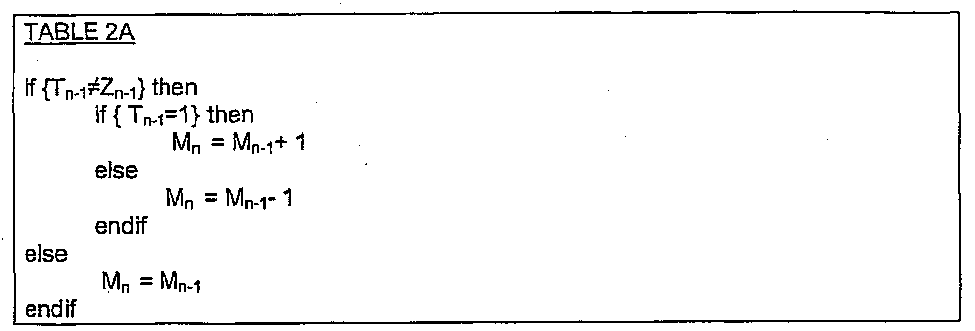

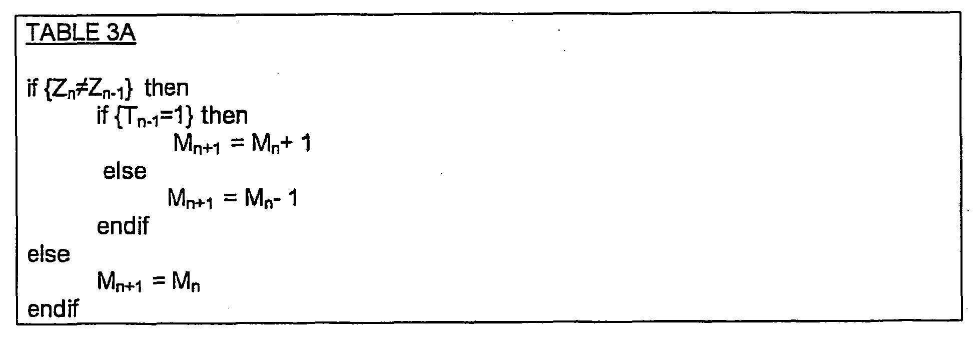

In the algorithms of Tables 1A, 2A, and 3A, "Tₙ", " is the value of the transition signal "T" at time index "n," "Mₙ" is the multi-bit count of the adaptation logic 1210 at time index "n," and "Zₙ" is the value of the data signal "Z" at time index "n."

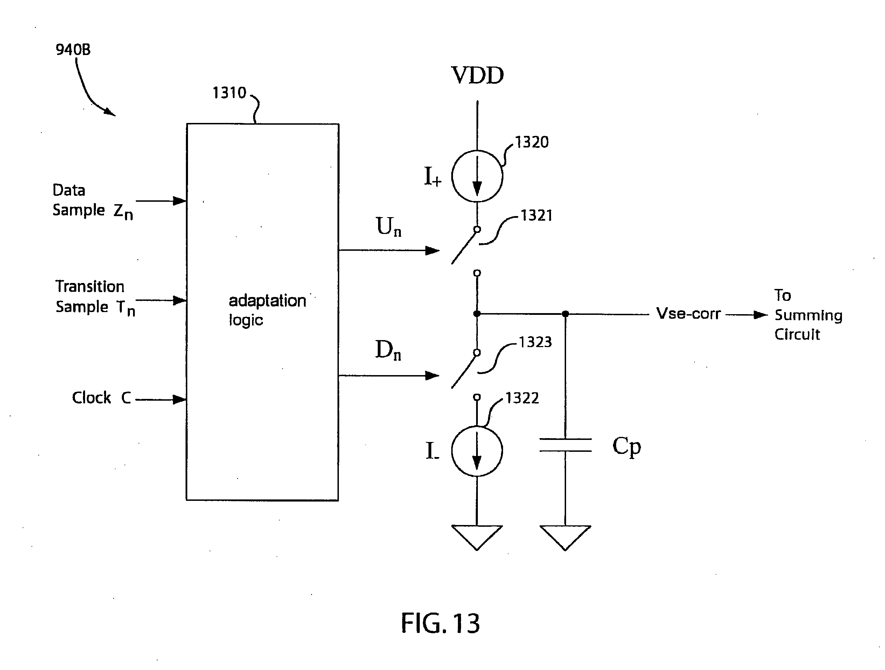

FIG. 13 schematically shows a DCD correction circuit 940B in accordance with an embodiment of the present invention. The DCD correction circuit 940B is an example single-ended implementation of the DCD correction circuit 940 shown in FIG. 9. The DCD correction circuit 940B may thus be readily employed in single-ended systems. In the example of FIG. 13, the DCD correction circuit 940B comprises an adaptation logic 1310 and a charge pump. The charge pump comprises a capacitor Cp, a DC current source 1320, a DC current sink 1322, and switches 1321 and 1323. The adaptation logic 1310 may comprise individual gates, programmable logic device, or other logic circuitry configured to perform the previously described first, second or third DCD correction algorithms. The adaptation logic 1310 may receive a data signal "Zₙ", a transition signal "Tₙ", and a clock signal "C" from a clock data recovery circuit (e.g., the CDR circuit 700 shown in FIG. 7).

In the example of FIG. 13, the DCD correction circuit 940B outputs an up signal "Uₙ" and a down signal "Dₙ" to control a charge pump formed by the capacitor Cp, the current source 1320, and the current sink 1322. In the example of FIG. 13, the up signal "Uₙ" is a logical signal that closes (Uₙ=1) and opens (Uₙ=0) the switch 1321. When the up signal "Uₙ" is a logical "1", the switch 1321 closes to allow the current source 1320 to charge the capacitor Cp. Similarly, the down signal "Dₙ" comprises a logical signal that closes (Dₙ =1) and opens (Dₙ = 0) the switch 1323. When the down signal "Dₙ" is a logical "1", the switch 1323 closes to allow the capacitor Cp to discharge through the current sink 1322. The capacitor Cp thus allows the charge pump to output a single-ended correction voltage V_{SE-CORR}, which may be a DC voltage that approximates a DC offset present in an input signal. The correction voltage V_{SE-CORR} may be subtracted from the input signal to remove DC offset from the input signal, and thereby minimize or eliminate duty cycle distortion in the input signal. Tables 1 B, 2B, and 3B show versions of the DCD correction algorithms of Tables 1, 2, and 3, respectively, which are adapted for the DCD correction circuit 940B. The algorithms of Tables 1 B, 2B, and 3B operate on essentially the same principles as those of Tables 1, 2, and 3, respectively.

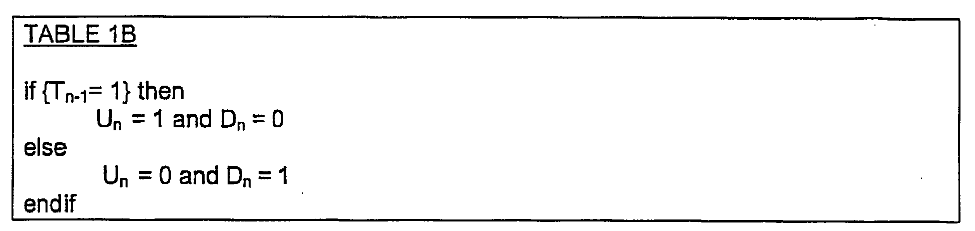

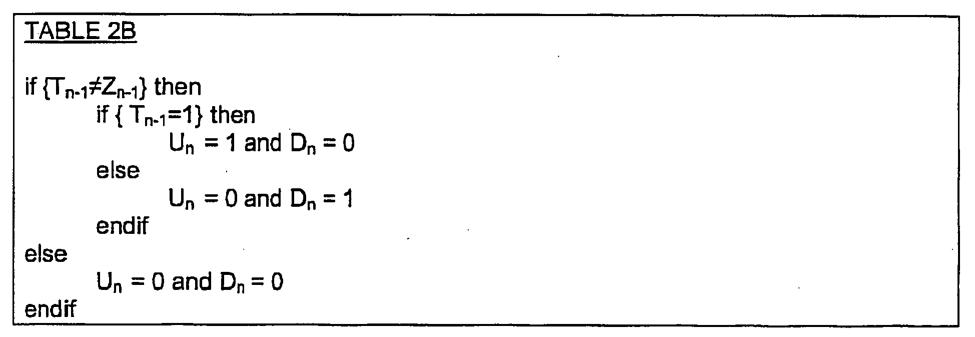

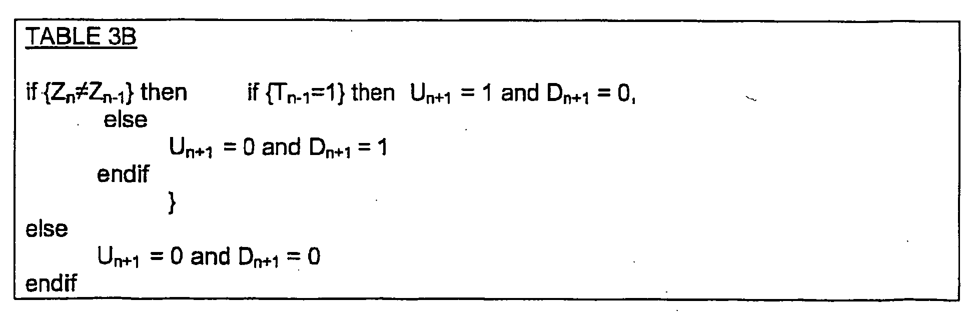

It is to be noted that the adaptation logic 1310 may be used with other charge pumps without detracting from the merits of the present invention. For example, differential charge pumps and charge pumps employing compensation circuits to balance the charging and discharging currents may also be employed in conjunction with the adaptation logic 1310.

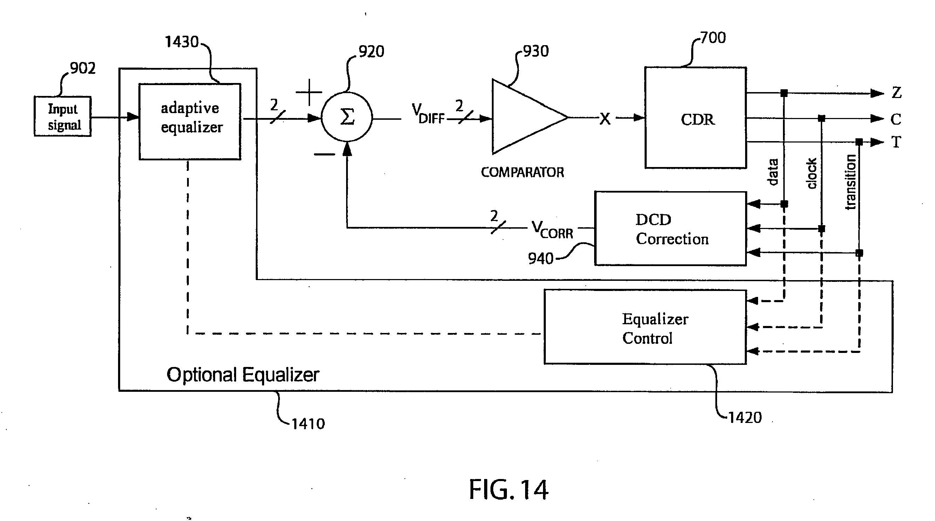

In light of the present disclosure, it can be appreciated that the DCD correction circuits disclosed herein may be adapted to work with other circuitry. For example, FIG. 14 schematically shows an optional equalizer 1410 that may be employed in conjunction with the DCD correction circuit 940 of FIG. 9. The equalizer 1410 compensates for the effects of the communication media (e.g. communication media 120 shown in FIG. 3) on transmitted signals. In the example of FIG. 14, the equalizer 1410 comprises an equalizer control 1420 and an adaptive equalizer 1430. In one embodiment, the equalizer control 1420 controls the adaptive equalizer 1430 such that the output of the adaptive equalizer 1430 has amplitude equalized across a range of frequencies of interest. The equalizer control 1420 may control the adaptive equalizer 1410 based on clock, data, and transition signals in the manner disclosed in commonly-assigned US Patent Application 10/685,560, filed on October 14, 2003, which is incorporated herein by reference in its entirety.

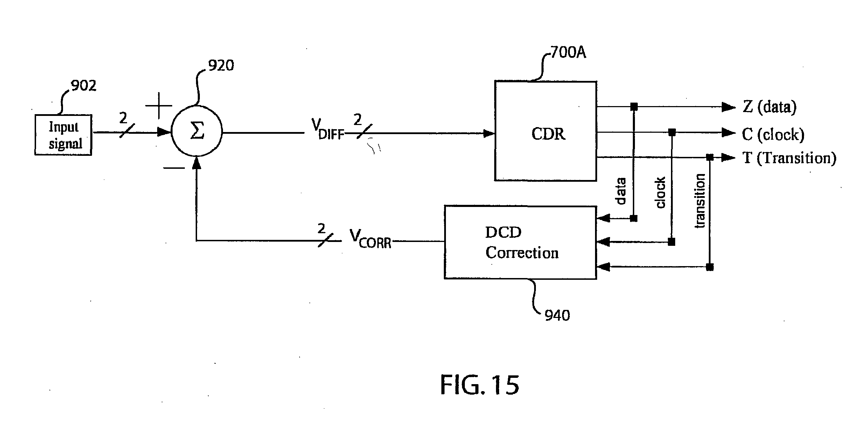

FIG. 15 schematically shows the DCD correction circuit 940 being employed with a CDR circuit 700A in accordance with an embodiment of the present invention. As will be more apparent below, the CDR circuit 700A is similar to the CDR circuit 700 of FIG. 7 except that the CDR circuit 700A accepts an analog differential voltage instead of a digital signal. Accordingly, in the example of FIG. 15, the CDR circuit 700A receives the differential voltage V_{DIFF} from the summer 920 without having to employ an intervening comparator. The CDR circuit 700A directly received the differential voltage signal V_{DIFF} and generates the data signal "Z", the clock signal "C", and transition signal "T."

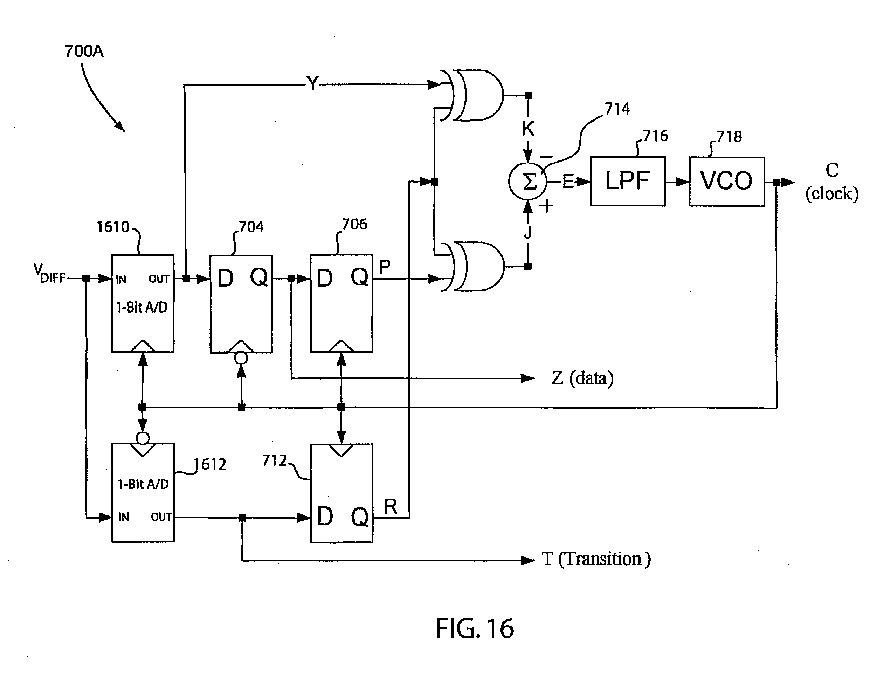

FIG. 16 schematically shows further details of the CDR circuit 700A in accordance with an embodiment of the present invention. Referring to FIGS. 7, 9, and 16, the comparator 930 is combined with the flip flop 702 in a single-bit analog-to-digital (A/D) converter 1610, which compares the voltages V_{DIFF+} and V_{DIFF-} to generate the logical signal "Y" at the rising edge of the clock signal "C". Similarly, the function of comparator 930 is combined with the flip flop 710 in a single-bit analog-to-digital converter 1612, which compares the voltages V_{DIFF+} and V_{DIFF-} and generates a logical transition signal "T" at the falling edge of the clock signal "C". The rest of the CDR circuit 700A operates in the same manner as the CDR circuit 700. In the CDR circuit 700A, the above described logic signal "X" (e.g. see FIG. 9), which serves as an intermediate signal between the comparator 930 and the flip flops 702 and 710, no longer exists explicitly. However, the underlying principles behind the clock data recovery and duty cycle distortion correction remain the same.

Improved methods and apparatus for correcting duty cycle distortion have been disclosed. While specific embodiments of the present invention have been provided, it is to be understood that these embodiments are for illustration purposes and not limiting. Many additional embodiments will be apparent to persons of ordinary skill in the art reading this disclosure.

## Claims

1. A method of correcting duty cycle distortion in a receiver, the method comprising:
receiving an input signal in the receiver,
generating a logical signal from the input signal;
sampling the logical signal to determine a DC offset in the input signal; and
correcting duty cycle distortion in the receiver by removing the DC offset from the input signal.

2. The method of claim 1 wherein sampling the logical signal to determine the DC offset in the input signal comprises:
recovering a clock signal and a data signal from the logical signal; and
generating a correction voltage based at least on the clock signal and the data signal.

3. The method of claim 2 wherein removing the DC offset from the input signal comprises:
applying the correction voltage to the input signal.

4. The method of claim 2 wherein recovering the clock signal and the data signal comprises:
passing the input signal to a clock and data recovery circuit.

5. The method of claim 2 further comprising:
generating a transition signal by sampling the logical signal at an edge of the clock signal where symbol transitions occur; and
generating the correction voltage based on a distribution of values of the transition signal.

6. The method of claim 5 wherein the correction voltage is adjusted only when two consecutive symbols of the data signal are not the same.

7. The method of claim 5 wherein the correction voltage is adjusted only when a value of the transition signal at a time index is not the same as a value of the data signal at the same time index.

8. The method of claim 1wherein the input signal comprises a non-retum to zero (NRZ) modulated differential voltage signal.

9. An apparatus for correcting duty cycle distortion in a communications system, the apparatus comprising:
a first circuit configured to receive an input signal and to output a logical signal that is a logical representation of the input signal;
a clock and data recovery (CDR) circuit configured to receive the logical signal and to output a recovered clock signal and a data signal from the logical signal;
a duty cycle distortion (DCD) correction circuit configured to generate a correction voltage based on the recovered clock signal and the data signal received from the CDR circuit, the correction voltage being indicative of a DC offset in the input signal; and
a second circuit configured to apply the correction voltage to the input signal to correct duty cycle distortion in the logical signal.

10. The apparatus of claim 9 wherein the input signal comprises a differential voltage signal, the first circuit comprises a comparator configured to compare two voltages of the input signal to generate the logical signal, and the second circuit comprises a summer configured to sum the correction voltage with the input signal.

11. The apparatus of claim 9 wherein the logical signal comprises an NRZ modulated signal.

12. The apparatus of claim 9 wherein the CDR circuit outputs a transition signal that represents values of the logical signal at edges of the clock signal where symbol transitions occur.

13. The apparatus of claim 9 wherein the DCD correction circuit adjusts the correction voltage only when at least two consecutive symbols of the data signal are not the same.

14. The apparatus of claim 12 wherein the DCD correction circuit is configured to generate the correction voltage based on a distribution of values of the transition signal.

15. The apparatus of claim 14 wherein the DCD correction circuit adjusts the correction voltage only when a value of the transition signal at a time index is not the same as a value of the data signal at the same time index.

16. The apparatus of claim 12 wherein the DCD correction circuit comprises:
an adaptation logic configured to generate a multi-bit count based on the data signal, the clock signal, and the transition signal; and
a digital to analog converter configured to generate the correction voltage based on the multi-bit count.

17. The apparatus of claim 12 wherein the DCD correction circuit comprises:
an adaptation logic configured to generate an up signal and a down signal based on the data signal, the clock signal, and the transition signal; and
a charge pump configured to generate the correction voltage based on the up signal and the down signal.

18. An apparatus for correcting duty cycle distortion in a communications system, the apparatus comprising:
comparison means for receiving an input signal and generating a corresponding logical signal;
recovery means for recovering a clock signal and a data signal from the logical signal; and
correction means for generating a correction voltage indicative of a DC offset in the input signal; and
removal means for removing the DC offset from the input signal using the correction voltage.

19. The apparatus of claim 18 wherein the correction means comprises:
logic means for generating a multi-bit count; and
conversion means for converting the multi-bit count to the correction voltage.

20. The apparatus of claim 18 wherein the correction means comprises:
logic means for generating up and down signals; and
pump means for charging/discharging a capacitor based on the up and down signals to generate the correction voltage.

21. A method of correcting duty cycle distortion in a receiver, the method comprising:
receiving a first signal in the receiver;
summing the first signal with a correction voltage to generate a second signal;
converting the second signal to a logical signal;
recovering a clock signal and a data signal from the logical signal;
sampling the logical signal at edges of the clock signal where bits of the logical signal transition to generate a transition signal; and
generating the correction voltage based at least on a distribution of values of the transition signal, the correction voltage being indicative of a DC offset in the second signal, and wherein summing the first signal with the correction voltage removes the DC offset from the first signal to correct duty cycle distortion in the receiver.

22. The method of claim 21 wherein the second signal comprises an analog differential signal converted to the logical signal using an analog-to-digital converter.

23. The method of claim 22 wherein the analog-to-digital converter comprises a single-bit analog-to-digital converter.

24. The method of claim 21 wherein the second signal comprises an analog differential signal converted to the logical signal using a comparator.

25. An apparatus for correcting duty cycle distortion in a receiver, the apparatus comprising:
a summer circuit configured to generate an analog signal, the analog signal being a sum of an input signal and a correction voltage;
a clock data recovery (CDR) circuit configured to receive the analog signal and generate a clock signal, a data signal, and a transition signal, the clock signal and the data signal being recovered by the CDR circuit from a logical signal that is a digital representation of the analog signal, the transition signal being samples of the logical signal at edges of the clock signal where data bits of the logical signal transition; and
a duty cycle distortion (DCD) correction circuit coupled to receive the clock signal, the data signal, and the transition signal, the DCD correction circuit being configured to generate a correction voltage based at least on a distribution of values of the transition signal, the correction voltage being indicative of a DC offset in the input signal, the correction voltage being summed with the input signal to remove DC offset from the input signal to correct duty cycle distortion in the receiver.

26. The apparatus of claim 25 wherein the CDR circuit includes an analog-to-digital converted configured to convert the analog signal to the logical signal.

27. The apparatus of claim 26 wherein the analog-to-digital converter comprises a single-bit analog-to-digital converter.

28. The apparatus of claim 25 wherein the analog signal is converted to the logical signal using a differential comparator.

29. The apparatus of claim 25 wherein the input signal comprises a differential NRZ modulated signal.

30. The apparatus of claim 25 wherein the CDR circuit comprises a binary phase detector.
